(19) Europäisches Patentamt
European Patent Office
Office européen des brevets

(11) Veröffentlichungsnummer: **0 114 341 B1**

(12) **EUROPÄISCHE PATENTSCHRIFT**

(45) Veröffentlichungstag der Patentschrift: **24.07.91**

(51) Int. Cl.$^5$: **G03F 7/105**

(21) Anmeldenummer: **83112810.3**

(22) Anmeldetag: **20.12.83**

# (54) Farbstoff enthaltende Schicht einer photopolymerisierbaren Mischung und Verfahren zur Herstellung von Relief- und Druckformen.

(30) Priorität: **28.12.82 DE 3248247**

(43) Veröffentlichungstag der Anmeldung:
**01.08.84 Patentblatt 84/31**

(45) Bekanntmachung des Hinweises auf die Patenterteilung:
**24.07.91 Patentblatt 91/30**

(84) Benannte Vertragsstaaten:
**AT BE CH DE FR GB IT LI NL**

(56) Entgegenhaltungen:
**DE-A- 2 749 639**
**FR-A- 1 532 373**
**GB-A- 1 144 547**
**JP-A-51 053 902**
**US-A- 4 356 254**
**FR-A- 1 481 818**
**FR-A- 2 503 399**
**GB-A- 1 366 769**
**US-A- 3 556 794**

(73) Patentinhaber: **BASF Aktiengesellschaft**
**Carl-Bosch-Strasse 38**
**W-6700 Ludwigshafen(DE)**

(72) Erfinder: **Bronstert, Bernd, Dr.**
**Zanderstrasse 35**
**W-6701 Otterstadt(DE)**
Erfinder: **Hoffmann, Gerhard, Dr.**
**Pappelstrasse 22**
**W-6701 Otterstadt(DE)**
Erfinder: **Lynch, John, Dr.**
**Bachusstrasse 15**
**W-6521 Monsheim(DE)**

**EP 0 114 341 B1**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft Schichten verbesserter photopolymerisierbarer Mischungen für die Herstellung von Relief- und Druckformen, die mindestens eine Verbindung mit mindestens einer photopolymerisierbaren olefinisch ungesättigten Doppelbindung, einen Photoinitiator sowie zur verbesserten Bildwiedergabe und insbesondere zur verbesserten Ausbildung von Zwischentiefen bei der Reliefformherstellung eine kleine Menge einer Kombination bestimmter organischer Verbindungen als Zusätze enthalten.

Schichten photopolymerisierbarer Mischungen für die Herstellung von Relief- und Druckformen sind vielfach beschrieben worden. Stellt man z.B. mit solchen bekannten Mischungen Reliefdruckplatten in den in der Druckindustrie üblichen Hochdruck-Reliefstärken von ca. 0,025 bis 1 mm her, so zeigen diese meist nicht die gewünschte scharfe Relieffeinstruktur und oft zu kleine Reliefflankenwinkel.

Es ist bekannt, daß man verbesserte Reliefformen erhalten kann, wenn man bei der Belichtung der Photopolymerplatten, d.h. der auf Träger aufgetragenen Schichten photopolymerisierbarer Mischungen, durch das bildtragende Negativ gewisse Kunstgriffe anwendet, mit mehrschichtigen photopolymerisierbaren Mischungen arbeitet oder unter der eigentlichen photopolymerisierbaren Aufzeichnungsschicht andere Schichten anordnet, die die Ausbildung der Reliefformen beeinflussen. Diese Verfahren sind jedoch umständlich.

Es ist auch bekannt, durch Zumischung geringer Mengen an bestimmten organischen Verbindungen die Reliefstruktur günstig zu beeinflussen. So werden in den DE-OS 27 20 560 und DE-OS 27 20 559 10,10'-Bisanthrone und 9-Nitroanthracen zu diesem Zweck beschrieben. Die Verbindungen sind auch in der Handhabung, z.B. im Löseprozeß, kritisch und verschlechtern infolge ihrer Eigenfarbe die visuelle Beurteilung der photopolymerisierten Mischungen vor und nach dem Entwicklungsprozeß. Auch beeinträchtigen sie die Differenzierung zwischen unbelichteten und belichteten Stellen bei der unentwickelten Form. Ähnliches gilt für Thioanthrachinonderivate, die in der DE-OS 27 59 163 zur Reliefstrukturverbesserung empfohlen werden.

Aus der US-A-3 556 794 ist eine Kombination aus einem Farbstoff und einem milden Reduktionsmittel, welches den Farbstoff nur beim Bestrahlen mit sichtbarem Licht reduzieren kann, bekannt. Diese Kombination wird zum Auslösen der Photopolymerisation mit sichtbarem Licht verwendet und kann in der Gegenwart eines Salzes einer Nitrobenzylcarbonsäure durch Bestrahlen mit UV-Licht desaktiviert werden.

Aus der DE-A-27 49 639 geht die Stabilisierung photopolymerisierbarer Mischungen gegen Hitze durch Ascorbinsäure oder Ascorbinsäurederivate hervor.

Eine Kombination von Eosinfarbstoffen und milden Reduktionsmitteln ist aus der GB-A-1 444 547 bekannt. Sie vermag beim Bestrahlen mit sichtbarem Licht die Photopolymerisation von Methylmethacrylat in der Gegenwart von Polymethylmethacrylat auszulösen.

Der vorliegenden Erfindung lag die Aufgabe zugrunde, durch geringe chemische Zusätze zu Schichten photopolymerisierbarer Mischungen zu erreichen, daß bei der bekannten Herstellung von Reliefformen daraus die Reliefstruktur verbessert wird, ohne daß durch die Zusätze die anderen Eigenschaften der photopolymerisierbaren Mischungen bei der Reliefformherstellung wesentlich negativ beeinflußt werden. Bevorzugt sollten diese Zusätze die erforderliche Mindestbelichtungszeit nicht nachteilig verändern. Ganz besonders war gewünscht, Zusätze zu den photopolymerisierbaren Mischungen zu finden, die gleichzeitig die Reliefstruktur verbessern und durch Änderung des Absorptionsverhaltens eine visuelle Beurteilung der bildmäßig belichteten Form vor dem Entwicklungsschritt ermöglichen, um im Falle von Fehlbelichtungen den zeit- und energieaufwendigen Entwicklungsprozeß zu sparen. Die Zusätze sollten zudem toxikologisch unbedenklich und in der Handhabung unproblematisch sein.

Es wurde nun überraschend gefunden, daß eine Schicht einer photopolymerisierbaren Mischung für die Herstellung von Relief- und Druckformen deutlich verbesserte Reliefstrukturen mit den gewünschten Verarbeitungseigenschaften gibt, wenn sie enthält:

(a) mindestens eine Verbindung mit mindestens einer photopolymerisierbaren olefinisch ungesättigten Doppelbindung,

(b) mindestens einen Photoinitiator, der bei Belichtung mit UV-Licht eine rasche Photopolymerisation in der Schicht auslöst und der kein Farbstoff ist, sowie

c) eine bei Belichtung mit aktinischem Licht einer Lichtquelle, die Maxima der Emission im Bereich der Absorption des verwendeten Photoinitiators (b) aufweist und die im Bereich der Absorptionsbande des verwendeten Farbstoffs (c1) eine ausreichende Emission hat, keine merkliche Photopolymerisation in der Schicht auslösende Kombination von

c1) 0,0001 bis 1 und bevorzugt 0,001 bis 0,2 Gewicht %, bezogen auf die Gesamttrockenmasse der Mischung, eines löslichen Farbstoffes der Formel (I)

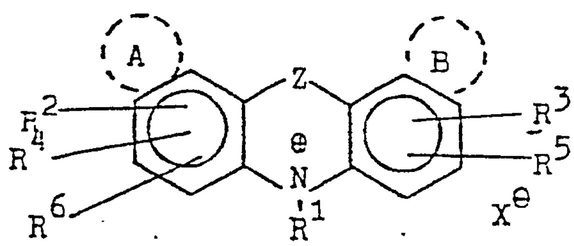

(I)

worin bedeuten

Z = N, O,S oder $CR^7$

$R^1$ = Wasserstoff, $C_1$-$C_4$-Alkyl, ggf. substituiertes Phenyl oder Naphthyl

$R^2$, $R^3$ = gleich oder verschieden = Wasserstoff, Hydroxy, $C_1$-$C_4$-Alkoxy, Phenoxy, ggf. substituiertes Diarylmethyl, oder $NH_2$, dessen H-Atome ganz oder teilweise durch gleiche oder verschiedene, ggf. substituierte Alkyl, Aryl oder Aralkylreste substituiert sein können,

$R^4$, $R^5$ = gleich oder verschieden = Wasserstoff, $C_1$-$C_4$-Alkyl, Phenyl, Hydroxy, $C_1$-$C_4$-Alkoxy, Sulfo oder $NH_2$, dessen H-Atome ganz oder teilweise durch gleiche oder verschiedene, ggf. substituierte Acyl-, Alkyl-, Aryl- oder Aralkylreste substituiert sein können,

$R^6$ = Wasserstoff, Hydroxy, $C_1$-$C_4$-Alkoxy, Carboxyl, Carbalkoxy, N-Acylamino oder Halogen,

$R^7$ = Wasserstoff, $C_1$-$C_4$-Alkyl oder ggf. substituiertes Aryl oder Aralkyl,

$X^\ominus$ = Säureanion,

A,B = gleich oder verschieden, Wasserstoff oder ankondensiertes Benzo-, Naphtho- oder Heterocyclensystem mit Ankondensation in a-, b- oder c-Stellung, mit der Maßgabe, daß, wenn A ein ankondensiertes Ringsystem der genannten Art ist, einer der Reste $R^2$ oder $R^4$ entfällt.

mit

(c2) einer hinreichenden Menge eines Reduktionsmittels für den Farbstoff (c1), das den Farbstoff (c1) ohne Bestrahlung durch das aktinische Licht nicht reduziert, bei Belichtung mit dem aktinischen Licht den Farbstoff im angeregten Elektronenzustand jedoch reduzieren kann.

Gegenstand der Erfindung ist weiterhin ein Verfahren zur Herstellung von Relief- und Druckformen durch bildmäßiges Belichten einer auf einen Träger aufgebrachten erfindungsgemäßen Schicht einer photopolymerisierbaren Mischung mit aktinischem Licht und Entwickeln der resultierenden Reliefform durch anschließendes Entfernen, insbesondere Auswaschen der unbelichteten Schichtanteile. Das Verfahren eignet sich dabei zur Herstellung von Reliefhochdruckformen, überraschenderweise aber auch besonders zur Herstellung von Photopolymerrelieftiefdruckformen.

Es war überraschend, daß Schichten photopolymerisierbarer Mischungen mit den erfindungsgemäßen Zusätzen selbst in kleinster Menge die Ausbildung der gewünschten Reliefformen deutlich verbessern, aber die photopolymerisierbaren Mischungen in ihren sonstigen Eigenschaften von den Zusätzen nicht wesentlich nachteilig beeinflußt werden. In den bevorzugten Fällen wird die Mindestbelichtungszeit der Schichten nicht wesentlich verändert. Dabei verleihen manche der zugesetzten erfindungsgemäß verwendeten Farbstoffe den photopolymerisierbaren Mischungen eine schöne Eigenfarbe. Prinzipiell können durch eine geeignete Auswahl der erfindungsgemäß zugesetzten Farbstoffe fast alle gewünschten Farbtöne in der Mischung erzeugt werden. Praktisch werden solche Farbstoffe als Zusätze bevorzugt, die eine visuelle Beurteilung der belichteten Form am günstigsten gestalten. Hier empfehlen sich ganz besonders rote Farbtöne, was aber keine Einschränkung der Erfindung bedeutet.

Besonders vorteilhaft ist eine äußerst schnelle, die Verarbeitung der photopolymerisierbaren Massen aber nicht wesentlich nachteilig beeinflussende Veränderung der Absorptionseigenschaften der Farbstoffzusätze während der bildmäßigen Belichtung. Dabei können je nach Farbstoffwahl innerhalb der vorgegebenen Farbstoffstrukturen die unterschiedlichsten gewünschten Effekte eingestellt werden, von einer totalen Ausbleichung der Farbstoffe bis zu einer Farbtonverschiebung von z.B. Blau nach Rot. Diese Eigenschaft der erfindungsgemäßen Schichten erleichtert beim erfindungsgemäßen Verfahren der Herstellung von Relief- und Druckformen erheblich die Beurteilung der belichteten Formen vor und nach der Entwicklung.

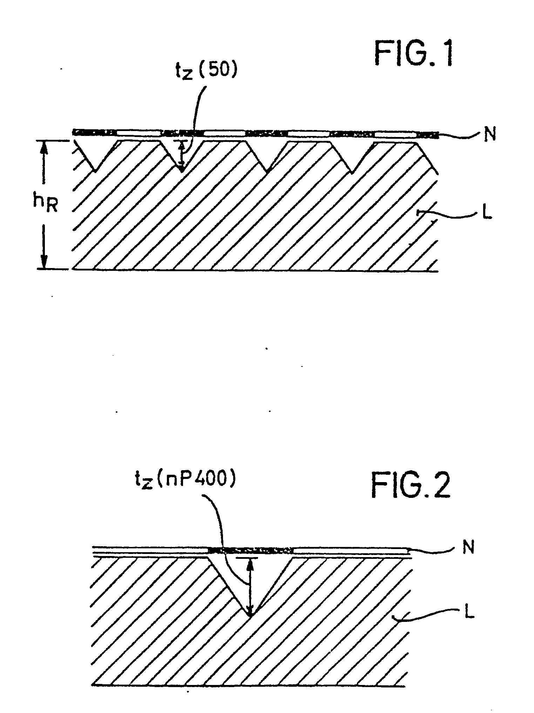

Zur besseren Beurteilung der Güte einer Reliefstruktur in verschiedenen Reliefelementen zieht man bekanntlich mit Vorteil die Ausmessung von Zwischentiefen in Rasterfeldern verschiedener Rasterweite und Tonwerte und von negativen Punkten mit 400 $\mu$m Durchmesser in einer Volltonfläche heran. In Figur 1 ist gezeigt, wie nach der Belichtung einer Schicht L aus einer photopolymerisierbaren Mischung mit aktinischem Licht durch ein Negativ N und Entwicklung durch Auswaschen der unpolymerisierten Anteile der Schicht L mit einem Entwicklerlösungsmittel ein Relief mit einer Reliefhöhe $h_R$ und den Zwischentiefen $t_z$

eines Rasters mit einem 50%-igen Tonwert erzeugt wird. Diese Meßgröße für die Zwischentiefe eines Rasters mit einem 50%igen Tonwert wird nachstehend als $t_z$ abgekürzt. In Figur 2 ist das gleiche für einen im Negativ N lichtundurchlässigen Punkt mit einem Durchmesser von 0,4 mm innerhalb einer im Verhältnis dazu großen lichtdurchlässigen Fläche dargestellt, nachstehend "negativer Punkt" genannt, wobei hier die Zwischentiefen mit $t_z$ (nP400) abgekürzt werden. Wie in den nachstehenden Beispielen gezeigt ist, kann mit den erfindungsgemäßen Mischungen bei der Herstellung von Reliefformen eine gravierende Verbesserung der Zwischentiefen und damit der Ausbildung der Relieffeinstruktur erreicht werden.

Es ist bekannt, Verbindungen und Farbstoffe der allgemeinen Formel (I), die statt $N^{\oplus}$ ein $C^{\oplus}$ enthalten und in denen Z als Brücke zwischen den beiden Arylkernen nicht existiert, also Di- oder Triphenylmethanfarbstoffe, die den erfindungsgemäß verwendeten Farbstoffen strukturell ähneln, einzusetzen. Diese ergeben aber keine Reliefstrukturverbesserung. Auch die häufig in photopolymerisierbaren Schichten eingesetzten strukturell ähnlichen Xanthenfarbstoffe der allgemeinen Formel (I) mit $C^{\oplus}$ statt $N^{\oplus}$ und Z = 0 geben die Effekte der erfindungsgemäßen Mischungen nicht und verbessern weder die Reliefstruktur noch ändern sie beim Belichten ihr Absorptionsverhalten.

Die erfindungsgemäßen bzw. erfindungsgemäß verwendeten Schichten enthalten als wesentlichen Teil- (a) ein oder mehrere Verbindungen mit mindestens einer photopolymerisierbaren olefinisch ungesättigten Doppelbindung. Hierbei lassen sich die bekannten für die Herstellung von Reliefformen und Photopolymerhoch-, -tief- und -offset-druckplatten verwendeten Monomeren, Oligomeren und ungesättigten Polymeren verwenden, deren Art sich nach dem Verwendungszweck der Mischungen, aber auch nach der Art der anderen Mischungskomponenten und bei der bevorzugten Mitverwendung von polymeren Bindemitteln in der Mischung nach der Art und Verträglichkeit mit diesen richtet. Bevorzugt sind Monomere mit zwei oder mehr olefinisch ungesättigten photopolymerisierbaren Doppelbindungen allein oder in Mischung mit Monomeren mit nur einer olefinisch ungesättigten photopolymerisierbaren Doppelbindung. Auch Polymere mit mehreren seiten- oder endständigen olefinisch ungesättigten Doppelbindungen sind anstelle von oder in Mischung mit den Monomeren verwendbar. Beispiele geeigneter Monomerer sind die Di- und Polyacrylate und -methacrylate, wie sie durch Veresterung von Diolen oder Polyolen mit Acrylsäure oder Methacrylsäure hergestellt werden können; wie die Di- und Tri(meth)acrylate von Ethylenglykol, Diethylenglykol, Triethylenglykol oder Polyethylenglykole mit einem Molekulargewicht bis etwa 500, 1,2-Propandiol, 1,3-Propandiol, Neopentylglykol (2,2-Dimethylpropandiol), 1,4-Butandiol, 1,1,1-Trimethylolpropan, Glycerin oder Pentaerythrit, ferner die Monoacrylate und Monomethacrylate solcher Diole und Polyole, wie z.B. Ethylenglykol-, Di-, Tri- oder Tetraethylenglykolmonoacrylat, Monomere mit zwei- oder mehr olefinisch ungesättigten Bindungen, die Urethangruppen und/oder Amidgruppen enthalten, wie die aus aliphatischen Diolen der vorstehend genannten Art, organischen Diisocyanaten und Hydroxyalkyl(meth)acrylaten hergestellten niedermolekularen Verbindungen. Genannt seien auch Acrylsäure, Methacrylsäure sowie deren Derivate wie (Meth)acrylamid, N-Hydroxymethyl(meth)acrylamid oder die (Meth)acrylate von Monoalkoholen mit 1 bis 6 C-Atomen.

Bevorzugt enthalten die Schichten der photopolymerisierbaren Mischungen auch polymere Bindemittel. Hierbei kommen als organische polymere Bindemittel für die photopolymerisierbaren Mischungen für die Herstellung von Reliefformen und Druckformen die bekannten dafür verwendeten Polymeren in Frage, wobei sie mit den mitverwendeten Monomeren im allgemeinen verträglich und - für den Fachmann selbstverständlich - in den Entwicklerlösungsmitteln löslich oder dispergierbar sein sollen, um ein Auswaschen der unbelichteten und unvernetzten Anteile einer Schicht der photopolymerisierbaren Massen nach ihrer bildmäßigen Belichtung zu ermöglichen. Als geeignete polymere, olefinisch gesättigte oder ungesättigte Bindemittel seien genannt ungesättigte Polyester, lineare Polyamide und besonders alkohollösliche Copolyamide, wie sie in der FR-PS 1 520 856 beschrieben sind, Cellulosederivate, insbesondere wäßrig-alkalisch auswaschbare Cellulosederivate, Vinylalkohol-Polymere sowie Polymere und Copolymere von Vinylestern aliphatischer Monocarbonsäuren mit 1 bis 4 C-Atomen, wie von Vinylacetat, mit unterschiedlichem Verseifungsgrad, Polyurethane wie Polyetherurethane und Polyesterurethane, Polyacrylsäure- und Polymethacrylsäureester, Styrol/Butadien-, Styrol/Isopren- oder Styrol/Butadien/Isopren-Copolymere, Styrol/Maleinsäureanhydrid- oder Styrol/Maleinsäure(halb)-ester-Copolymerisate, Styrol/Maleinsäureanhydrid/(Meth)acrylsäure-Copolymerisate, modifizierte Polyvinylalkoholderivate wie z.B. Polyvinylbutyral oder das in der DE-OS 30 15 340 erwähnte Umsetzungsprodukt eines Polyvinylalkohols mit einem gewissen Teil eines (Meth)Acrylsäureanhydrids. Als polymere Bindemittel sind für die Herstellung von Reliefdruckformen für den Flexodruck auch elastomere Dien-Polymere und -Copolymere wie von Butadien und/oder Isopren geeignet, von denen Blockcopolymere, die Butadien- und/oder Isopren-Homopolymerblöcke und Polymerblöcke aus Styrol oder α-Methylstyrol enthalten, besonders geeignet sind. Der Gehalt der photopolymerisierbaren Mischungen an polymerem Bindemittel richtet sich nach ihrer Verwendung, er beträgt im allgemeinen etwa 5 bis 90 und insbesondere 45 bis 80 Gew.%, bezogen auf die Summe der Mengen an Polymeren und photopolymerisierbaren Monomeren. Welche Monomere, ungesättigte Oligomere oder ungesättigte Polymere vorteilhaft mit welchen polymeren Bindemitteln kombiniert werden können, kann der Patentliteratur entnommen werden.

Die erfindungsgemäßen bzw. erfindungsgemäß verwendeten Schichten der photopolymerisierbaren Mischungen enthalten in bekannter Weise mindestens einen Photoinitiator, im allgemeinen in Mengen von 0,01 bis 10 und insbesondere 0,01 bis 3 Gew.%, bezogen auf die Trockenmasse der Mischung. Als Photoinitiatoren sind dabei solche Verbindungen geeignet, die bei Einwirkung von aktinischem Licht Radikale zu bilden vermögen, und eine rasche Photopolymerisation in der Schicht auslösen. Als Photoinitiatoren kommen z.B. in Frage Acyloine und Acyloinether, aromatische Diketone und deren Derivate und mehrkernige Chinone. Sehr geeignet sind Benzoin- und α-Hydroxymethylbenzoin und besonders deren Alkylether mit 1 bis 8 C-Atomen wie Benzoin-isopropylether, α-Hydroxymethyl-benzoinmethylether oder Benzoinmethylether, Benzilmonoketale wie Benzil-dimethylketal, Benzil-methyl-ethylketal,Benzil-methyl-benzylketal, Benzil-neopentylketal oder Diarylphosphinoxide wie sie in der DE-OS 29 09 992 beschrieben sind. Bevorzugt sind Photoinitiatoren, in Art und Menge, daß sie für die Auslösung der Photopolymerisation bei bildmäßiger Belichtung mit aktinischem Licht, insbesondere UV-Licht, nur kurze Mindestbelichtungszeiten, bevorzugt nicht mehr als wenige Minuten, benötigen. Die Photoinitiatoren (b) sind bevorzugt keine Farbstoffe.

Ein besonderes Merkmal der erfindungsgemäßen Schichten ist, daß sie zusätzlich zu den Photoinitiatoren eine Mischung bestimmter Farbstoffe (c1) mit milden Reduktionsmitteln (c2) für den mitverwendeten jeweiligen Farbstoff (c1) aufweisen. Die Mischung (c1) + (c2) soll dabei bei der bildmäßigen Belichtung mit aktinischem Licht keine merkliche Photopolymerisation in der Schicht der photopolymerisierbaren Mischung auslösen, was mit wenigen Versuchen feststellbar ist. Beträgt z.B. die Belichtungszeit für erfindungsgemäße, bevorzugt im wesentlichen lösungsmittelfreie, Schichten der photopolymerisierbaren, den Photoinitiator (b) enthaltenden Mischung X Sekunden oder Minuten, so sollte die entsprechende Schicht, die den Photoinitiator (b) nicht enthält, mit Vorteil auch bei Anwendung der zehnfachen Belichtungszeit beim anschließenden Entwickeln der Reliefform durch Auswaschen keine merklichen Anteile an photopolymerisierter Schicht aufweisen, in jedem Fall sollten weniger als 20 Gew.% der belichteten Monomerenmengen photopolymerisiert sein.

Als Farbstoffe (c1) der angegebenen Formel (I) für die photopolymerisierbaren Mischungen eignen sich vor allem solche aus der Reihe der Phenoxazinfarbstoffe der Formel (II):

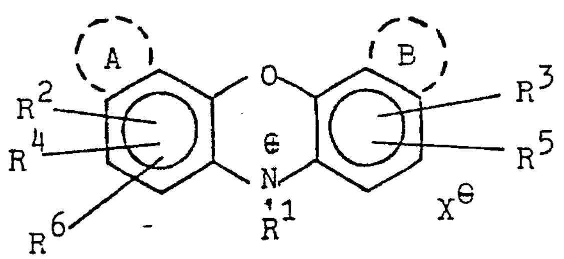

(II),

wobei $X^{\ominus}$, A, B sowie $R^1$ bis $R^6$ die angegebenen Bedeutungen haben. Als Beispiele sehr geeigneter Farbstoffe seien genannt: Capriblau GN (C.I. 51000), Zaponechtblau 3 G (C.I.51005), Galloblau E (C.I. (51030),Echtneublau 3 R (C.I. 51175), Nilblau A (C.I. 51180), Echtgrün M (C.I. 51210), Echtschwarz L (C.I. 51215), sowie Rhodanilblau, dem Salz bzw. Amid aus Rhodamin B (Basic Violet 10, C.I. 45170) und Nilblau (Basic Blue 12, C.I. 51180).

Bevorzugt sind Verbindungen aus der Reihe der Phenaziniumfarbstoffe der Formel (III):

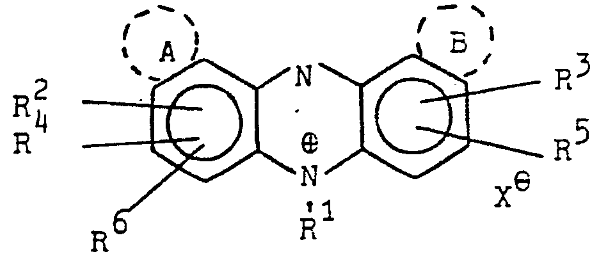

(III),

wobei $X^{\ominus}$, A, B sowie $R^1$ bis $R^6$ die oben angeführten Bedeutungen haben. Als Beispiele sehr geeigneter

Farbstoffe seien hier genannt: Neutralrot (C.I. 50040), Neutralviolett (C.I. 50030), Azinscharlach G (C.I. 50045), Rhodulinheliotrop 3 B (C.I. 50055), Neutralblau C (C.I. 50150), Azingrün GB (C.I. 50155), Safranin B (C.I. 50200), Indaminblau B (C.I. 50204), Rhodulinrot G (C.I. 50215), Rhodulinblau GG extra (C.I. 50220), Indazin GB (C.I. 50221), Safranin T (C.I. 50240, Mauvein (C.I. 50245), Naphthylrot (C.I. 50370) sowie Nigrosinschwarz T (C.I. 50415).

Genannt seien-ferner die Acridiniumfarbstoffe der Formel (IV)

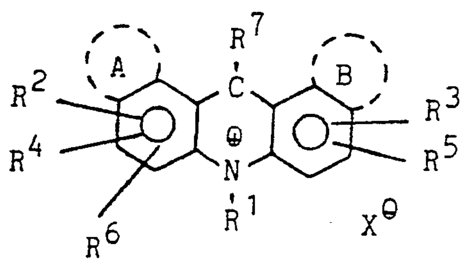

IV,

wobei $X^\ominus$, A, B, $R^1$ bis $R^7$ die oben angeführten Bedeutungen von denen als geeignete Farbstoffe angeführt seien: Acriflavin (C.I. 46000), Acridinorange (C.I. 46005), Acridinscharlach J (C.I. 46015), Acridingelb G (C.I. 46025), Aurazin G (C.I. 46030), Diamantphosphin GG (C.I. 46035), Phosphin E (C.I. 46045), Flaveosin (C.I. 46060), Benzoflavin (C.I. 46065) und Rheonin A (C.I. 46075).

Ferner genannt seien die Phenothiaziniumfarbstoffe der Formel (I) mit Z = S, z.B. Methylenblau oder Thionin.

Zum besseren Verständnis der Formeln (I) bis (IV) seien die nachstehenden Beispiele für die Reste $R^1$ bis $R^7$, A, B und $X^\ominus$ geeigneter Farbstoffe angeführt:

Beispiele für den Rest $R^1$ sind Wasserstoff, Methyl, Ethyl, 2-Methoxyphenyl, 4-Methylphenyl, 2,4-Dimethylphenyl, 2-Methylphenyl, 4-Sulfophenyl, 2-Methyl-3-sulfophenyl, 1-Naphthyl, 2-Naphthyl, 5,8-Disulfo-2-naphthyl. Beispiele für die Reste $R^2$ und/oder $R^3$ sind Wasserstoff, Hydroxy, Methoxy, Di(p-diethylamino-phenyl)methyl, Amino, N-Methylamino, N-Ethylamino, Dimethylamino, Diethylamino, N-Phenylamino, N-(4-Sulfophenyl)amino,N-(2,4-Disulfophenyl)amino, N-(2-Sulfo-4-amino-phenyl)-amino, N-(2-methylphenyl)amino, N-(3-Methoxyphenyl)amino, N(4-Diethylaminophenyl)amino, N-(4-Dimethylaminophenyl)amino, N-(2-Sulfo-4-methylamino-5-methylphenyl)amino, N-(5,8-Disulfonaphthyl)amino, N-Ethyl-N--benzylamino, Phenaziniumylamino, Oxaziniumylamino, oder Rhodaminylamino. Beispiele für die Reste $R^4$ und $R^5$ sind Wasserstoff, Methyl, Methoxy, Sulfo, N-Methylamino, N-Ethylamino, Dimethylamino, Diethylamino, N-Phenylamino und N(4-Diethylaminophenyl)amino. Beispiele für den Rest $R^6$ sind Wasserstoff, Hydroxy, Methoxy, Chloro, Bromo, Carboxyl, Carbmethoxy oder N-Acetylamino. Beispiele für den Rest $R^7$ sind Wasserstoff, Methyl, Ethyl, Phenyl, 4-Aminophenyl oder 2-Carboxyphenyl.

Beispiele für das Säureanion sind $C1^\ominus$ , $Br^\ominus$ ,

$$ClO_4^\ominus, \; HSO_4^\ominus,$$

$CH_3SO_4^\ominus$ und ähnliche bekannte, insbesondere einwertige anorganische und organische Säureanionen. Sehr geeignete Salze sind oft die Chlorhydrate. Beispiele für die Reste A und B sind Wasserstoff Benz [a], Dibenz [a,c], Dibenz [a,f], Dibenz [a,d,], Tetrabenz [a,c,d,f], ggf. substituiert,

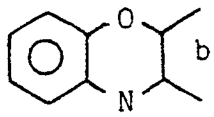 , 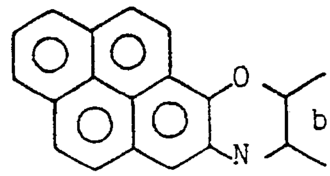

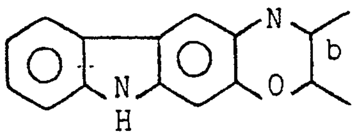 und 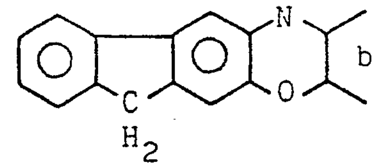

Die Auswahl des in der photopolymerisierbaren Mischung verwendeten Farbstoffs (c1) wird vor allem vom ästhetischen Eindruck mit bestimmt. So ist z.B. eine visuelle Beurteilung der Druckplatten besonders einfach mit den Verbindungen Neutralrot (C.I. 50040), Safranin T (C.I. 50240) sowie Rhodanilblau (siehe oben), die bevorzugt in der photopolymerisierbaren Mischung verwendet werden.

Die erfindungsgemäßen Schichten enthalten in Kombination mit dem Farbstoff (c1) eine für diesen hinreichende Menge eines Reduktionsmittels für den Farbstoff (c1), das den mitverwendeten Farbstoff (c1) in Abwesenheit von aktinischem Licht nicht reduziert, bei Belichtung den Farbstoff im angeregten Elektronenzustand jedoch reduzieren kann, insbesondere zum Semichinon. Beispiele solcher milden Reduktionsmittel sind Ascorbinsäure, Anethol, Thioharnstoff, Diethylallylthioharnstoff, Hydroxylamin-derivate, insbesondere N-Allylthioharnstoff und bevorzugt Salze des N--Nitrosocyclohexyl-hydroxylamins, insbesondere die Kalium- und Aluminiumsalze. Letztere sind auch als Inhibitoren gegen die thermische Polymerisation in photopolymerisierbaren Mischungen bekannt. Die Menge der zugesetzten Reduktionsmittel beträgt im allgemeinen etwa 0,005 bis 5 und insbesondere 0,01 bis 1 Gew.%, bezogen auf die Gesamttrockenmasse der Mischung, soll jedoch nicht weniger als das Reduktionsäquivalent der Menge des verwendeten Farbstoffs (c1) betragen. In vielen Fällen hat sich der Zusatz des 3- bis 10-fachen der Menge an mitverwendetem Farbstoff (c1) bewährt.

Im allgemeinen enthalten die photopolymerisierbaren Mischungen auch Inhibitoren gegen die thermische Polymerisation, wie Hydrochinon, p-Methoxyphenol, Dinitrobenzol, p-Chinon, Methylenblau, ß-Naphthol, N-Nitrosamine wie N-Nitrosodiphenylamin, Phenothiazin, Phosphorigsäureester wie Triphenylphosphit oder die Salze und insbesondere die Alkali- und Aluminiumsalze des N-Nitroso-cyclohexyl-hydroxylamins. Die Inhibitoren werden den photopolymerisierbaren Mischungen im allgemeinen in einer Menge von 0,001 bis 3 Gew.% und insbesondere in einer Menge von 0,003 bis 1 Gew.% der Mischung zugemischt.

In bekannter Weise können die erfindungsgemäßen bzw. erfindungsgemäß verwendeten Mischungen natürlich auch weitere übliche Zusätze wie Weichmacher, gesättigte niedermolekulare Verbindungen mit Amid- oder Alkoholgruppen, Wachse, Pigmente usw. So enthalten bevorzugte Mischungen für die Herstellung von Tiefdruckformen feinteilige Pigmente wie Quarzmehl.

Beispiele sehr geeigneter fester Schichten photopolymerisierbarer Mischungen enthielten:

a) 35 bis 90 Gew.% eines polymeren Bindemittels wie eines Copolyamids oder Polyvinylalkohols oder eines elastomeren Homo- oder Copolymeren,

b) 6 bis 60 Gew.% und insbesondere 8 bis 45 Gew.% mindestens einer niedermolekularen Verbindung (a) mit mehr als einer photopolymerisierbaren olefinisch ungesättigten Doppelbindung oder deren Gemisch mit einer niedermolekularen Verbindung mit nur einer photopolymerisierbaren olefinisch ungesättigten Doppelbindung,

c) 0,2 bis 6 Gew.% eines Photoinitiators (b),

d) 0,001 bis 2 Gew.% eines Inhibitors gegen thermische Polymerisation,

e) 0,0001 bis 1, vorzugsweise 0,0001 bis 0,1 Gew.% eines Farbstoffs (c1) der Formel (I) sowie

f) 0,005 bis 5 Gew.% eines Reduktionsmittels (c2).

Beispiele sehr geeigneter Schichten flüssiger photopolymerisierbarer Mischungen enthielten

a) 45 bis 75 Gew.% eines ungesättigten Polyesters einer Säurezahl von 100 bis 150,

b) 15 bis 25 und insbesondere 10 bis 20 Gew.% einer mindestens eine Allylgruppe enthaltenden

Monomeren mit zwei olefinisch ungesättigten Doppelbindungen,
c)5 bis 25 Gew.% eines Monomeren mit mindestens einer (Meth)acrylat-Gruppe
d) 1 bis 10 Gew.% einer gesättigten oder olefinisch ungesättigten niedermolekularen Verbindung mit mindestens einer Amidgruppe,
e) 0,2 bis 4 Gew.% eines Photoinitiators (b),
f) 0,003 bis 1 Gew.% eines Inhibitors gegen thermische Polymerisation,
g) 0,0001 bis 1, vorzugsweise 0,0001 bis 0,1 Gew.% eines Farbstoffs (c1) der Formel (I), sowie
h) 0,005 bis 5 Gew.% eines Reduktionsmittels (c2).

Bezüglich geeigneter photopolymerisierbarer Mischungen für die Herstellung von Tiefdruckformen, denen erfindungsgemäß lösliche Farbstoffe (c1) und Reduktionsmittel (c2) zugemischt werden können, sei auf die DE-OS 31 28 949 verwiesen. Sie enthalten insbesondere als polymeres Bindemittel ein alkohollösliches Copolyamid der oben angegebenen Art, vorteilhaft in einer Menge von 20 bis 93 und insbesondere 45 bis 87 Gew.%. In einer Menge von 2 bis 50 und insbesondere 5 bis 25 Gew.% der Mischung enthalten sie in inniger Mischung ein feinteiliges Pigment, bevorzugt feinstteiliges Quarzmehl. Als Verbindung mit photopolerisierbaren olefinisch ungesättigten Doppelbindungen hat sich in Kombination mit alkohollöslichen Copolyamiden besonders der Diether aus 2 Mol N-Methylolacrylamid und 1 Mol Ethylenglykol bewährt, der im allgemeinen in einer Menge von 2 bis 50 und insbesondere 5 bis 25 Gew.% verwendet wird. Es war überraschend, daß die erfindungsgemäßen Schichten auch bei der Herstellung von Tiefdruckformen einen so deutlich verbessernden Effekt auf die resultierende Tiefdruckform, ihre Näpfchentiefe und deren Gehalt auch bei Über belichtung zeigen.

Die Verarbeitung der photopolymerisierbaren Mischungen zu Photopolymerdruckplatten, die schichtförmig die Mischungen als reliefformende Schichten auf einem Träger aufweisen, in an sich bekannter Weise erfolgen und ist von der Art der Mischung und davon abhängig, ob die Mischung flüssig oder fest ist. Die Verarbeitung der Schichten bzw. Druckplatten zu Reliefformen erfolgt in bekannter Art durch bildmäßiges Belichten mit aktinischem Licht, insbesondere mit Lichtquellen, die Maxima der Emission im Bereich der Absorption der verwendeten Photoinitiatoren, im allgemeinen im Bereich von 300 bis 400 nm, sowie im Bereich der Absorptionsbande des verwendeten Farbstoffs (c1) eine ausreichende Emission besitzen oder einen ausreichenden Anteil von Licht dieses Wellenlängenbereiches aufweisen, wie Quecksilbermitteldruckstrahler, aber auch Hoch- und Niederdruckstrahler, oder superaktinische Leuchtstoffröhren. Nach der bildmäßigen Belichtung werden die nichtbelichteten Anteile der Schicht der photopolymerisierbaren Mischung in bekannter Art mechanisch entfernt und/oder mit Entwicklerlösungsmitteln ausgewaschen und die resultierende entwickelte Reliefform getrocknet, in manchen Fällen zweckmäßigerweise noch einer Vollbelichtung unterworfen. Im Fall der Herstellung von Tiefdruckformen ist eine längere Trocknung bei Temperaturen von ca. 70 bis 100 °C zweckmäßig. Die in den folgenden Beispielen und Vergleichsversuchen genannten Teile und Prozente beziehen sich, soweit nicht anders angegeben, auf das Gewicht. Teile verhalten sich zu Volumenteilen wie Kilogramm zu Liter.

Beispiel 1

Zu 650 Teilen eines ungesättigten Polyesters aus Fumarsäure, Trimellithsäureanhydrid und Diethylenglykol mit einer Säurezahl von 140 werden 400 Teile ein s Gemisches gleicher Mengen von Tetraethylenglykoldimethacrylat und Diallylphthalat, 55 Teile Methacrylamid, 2 Teile Hydrochinon, 1,4 Teile N-Allylthioharnstoff und 8 Teile Benzoinethylether zugemischt. Der resultierenden flüssigen Mischung werden 0,0075 Gew.% Safranin T (C.I. 50240) zugemischt.

In an sich bekannter Art werden aus der photopolymerisierbaren Mischung Reliefformen hergestellt. Hierzu werden die flüssigen Mischungen schichtförmig auf mit Haftlack versehene Stahlbleche als Träger gegossen, mit einem Rakel Schichtstärken von 800 $\mu$m eingestellt und danach die Schichten unter Vermeidung von Lufteinschlüssen mit einer 9 $\mu$m starken transparenten Polyesterfolie abgedeckt.

Die flüssigen Harzschichten werden durch auf die Polyesterfolie aufgelegte Negative mit einer handelsüblichen UV-Mitteldrucklampe bildmäßig belichtet. Negative und Polyesterfolien werden entfernt und danach werden die unbelichteten Anteile der Schichten der Mischung mit einer 0,5%igen wäßrigen Soda-Lösung ausgewaschen. Die resultierenden Reliefformen werden getrocknet und jeweils 2 Minuten nachbelichtet.

Die Auswertung der hergestellten Reliefstrukturen, die in Tabelle 1 wiedergegeben ist, zeigt die vorteilhafte Ausbildung klebfreier, scharf ausgebildeter Flanken mit vorteilhaften Zwischentiefen eines Rasters mit einem 50%igen Tonwert ($t_z$(50)) und eines negativen Punkts ($t_z$(nP400)).

Vergleichsversuch 1

Es wird genau wie in Beispiel 1 verfahren, jedoch wird der Zusatz von Safranin T zur photopolymerisierbaren Schicht unterlassen. Die Auswertung der Reliefstruktur ist in Tabelle 1 wiedergegeben und zeigt eine unbefriedigende Ausbildung der Zwischentiefen $t_z$ (50) und $t_z$ (nP400) sowie der Flanken. Die Flanken der ausgewaschenen Druckform sind stark klebrig.

Tabelle 1 Auswertung der Reliefstruktur, hergestellt gemäß Beispiel 1 und Vergleichsversuch 1 (Raster: 28 L/cm)

| | Beispiel 1 | Vgl.versuch 1 |
|---|---|---|
| Mindestbelichtungszeit für Raster mit 3 %-igem Tonwert | 20 Sek. | 20 Sek. |
| Zwischentiefe für Raster mit 50%-igem Tonwert $t_z$ (50) | 155 µm | 71 µm |
| Zwischentiefe des negativen Punktes 0,4 mm Ø $t_z$ (nP400) | 350 µm | 48 µm |
| Flanken | klebfrei, scharf ausgebildet | klebrig, unscharf ausgebildet |

Beispiel 2

Eine Lösung von 167 Teilen eines Polystyrol-Polybutadien-Polyisopren-Dreiblockcopolymeren mit einem Gehalt von 18 % an einpolymerisierten Styrol-Einheiten, 12,5 Teilen eines präpolymeren Styrols, 0,33 Teilen 2,6-Di-tert-butyl-4-methylphenol, 10 Teilen Hexandiol-1,6-diacrylat, 6,7 Teilen Laurylacrylat, 2 Teilen α-Methylolbenzoinmethylether und 0,2 Teilen Aluminiumsalz des N-Nitrosocyclohexyl-hydroxylamins in 160 Teilen Toluol und 10 Teilen n-Propanol wird mit 0,1 Gew.% Neutralrot (C.I. 50040) und 1 Gew.-% Ascorbinsäure, bezogen auf den Feststoffgehalt der Mischung, vermischt und danach mittels eines Rakels auf eine mit einem Haftvermittler versehene 125 µm starke Polyesterfolie aufgegossen und getrocknet. Die resultierende Photopolymerdruckplatte mit einer 670 µm dicken Schicht der photopolymerisierbaren Mischung wird mit aktinischem Licht bildmäßig belichtet und in einem Sprühwascher mit einem Trichlorethylen-Isopropanol-Gemisch die Reliefform durch Auswaschen der unbelichteten Anteile entwickelt. Die Ergebnisse der Auswertung der Reliefstrukturen sind in Tabelle 2 wiedergegeben. Bei nicht verlängerter Mindestbelichtungszeit bildet sich eine vorteilhafte Zwischentiefe aus.

Vergleichsversuch 2

Es wird genau wie in Beispiel 2 verfahren, jedoch die Zumischung des Neutralrots unterlassen. Die Auswertung der Reliefstruktur ist in Tabelle 2 wiedergegeben und zeigt eine unzureichende Ausbildung der Zwischentiefen $t_z$(50) und $t_z$(nP400).

Tabelle 2 Auswertung der Reliefstrukturen, hergestellt gemäß Beispiel 2 und Vergleichsversuch 2 (Raster: 28 L/cm)

| | Beispiel 2 | Vgl.versuch 2 |
|---|---|---|
| Mindestbelichtungszeit für Raster mit 3 %igem Tonwert | 12 Min. | 12 Min. |
| Zwischentiefe für Raster mit 50%igem Tonwert $t_z(50)$ | 105 µm | 45 µm |
| Zwischentiefe des negativen Punktes 0,4 mm Ø $t_z$ (nP400) | 165 µm | 65 µm |

Belichtet man die Druckplatten aus Beispiel 2 zweimal so lang wie die erforderliche Mindestbelichtungszeit, so nimmt der Wert für $t_z$ (nP400) von 165 auf 140 µm ab, während die Vergleichsplatte nach Vergleichsversuch 2 nach 24 Minuten Belichtung praktisch keine Zwischentiefe mehr aufweist ($t_z$(nP400) (15 µm).

Beispiel 3

Eine 65%ige methanolische Lösung einer photopolymerisierbaren Mischung aus 60 % eines Copolyamids aus Adipinsäure, Hexamethylendiamin, 4,4'-Diaminodicyclohexylmethan und ε-Caprolactam, 25 % des Diethers aus 1 Mol Ethylenglykol und 2 Molen N-Hydroxymethyl-acrylamid, 13,5 % Benzolsulfonamid und 1,5 % Benzointetrahydropyranylether, 0,2 % des Kaliumsalzes des N-Nitrosocyclohexylhydroxylamins sowie 0,02 % Safranin T (C.I. 50240) wird hergestellt. Die Lösung der Mischung wird schichtförmig auf ein mit einem Haftlack versehenes Stahlblech (Reflexionsgrad ca. 15 %) so aufgegossen, daß nach dem Trocknen bei etwa 70° C eine Schicht der photopolymerisierbaren Mischung mit einer Schichtstärke von 500 µm entsteht. Die Schicht der Mischung (Druckplatte) wird bildmäßig durch eine Vorlage belichtet. Bei der Belichtung in einem handelsüblichen Flachbelichter, bestückt mit superaktinischen Leuchtstoffröhren ($\lambda_{max}$ 350 - 400 nm), erfolgt in den belichteten Schichtanteilen ein Farbumschlag von rot nach blaßrot. Visuelle Beurteilung: gut. Mit einem Alkohol-Wasser-Gemisch werden dann die unbelichteten Schichtanteile der Mischung ausgewaschen.

Die Auswertung der hergestellten Reliefstrukturen, die in Tabelle 3 wiedergegeben ist, zeigt eine vorteilhafte Ausbildung klebfreier, scharf ausgebildeter Flanken mit vorteilhaften Zwischentiefen eines Rasters mit einem 50%igen Tonwert ($t_z$(50)) und eines negativen Punkts ($t_z$(nP400)).

Beispiel 3a

Es wird wie in Beispiel 3 verfahren, jedoch anstelle des Kaliumsalzes des N-Nitrosocyclohexylamins die gleiche Menge an N-Allylthioharnstoff verwendet. Die Auswertung der Reliefstrukturen zeigt Tabelle 3.

Vergleichsversuch 3

Es wird wie in Beispiel 3 verfahren, jedoch der Zusatz von Safranin T zur photopolymerisierbaren Mischung unterlassen. Die Auswertung der Reliefstruktur ist in Tabelle 3 wiedergegeben und zeigt eine unbefriedigende Ausbildung der Zwischentiefen $t_z$(50) und $t_z$(nP400) sowie der Reliefflanken. Bei der Belichtung erfolgt kein Farbumschlag. Die Platten können demzufolge vor dem Auswaschen kaum beurteilt werden.

Tabelle 3 Auswertung der Reliefstrukturen, hergestellt gemäß Beispielen 3 und 3a sowie Vergleichsversuch 3

| | Beisp.3 | Beisp.3a | Vgl.vers.3 |
|---|---|---|---|
| Mindestbelichtungszeit für Raster mit 3%igem Tonwert 60 L/cm | 2,0 Min. | 2,2 Min. | 2,0 Min. |
| Zwischentiefe für Raster (60 L/cm mit 50%igem Tonwert $t_z$(50) | 64 µm | 45 µm | 20 µm |
| Zwischentiefe des negativen Punktes 0,4 mm Ø $t_z$ (nP400) | 240 µm | 160 µm | 17 µm |

Beispiel 4

Es wird wie in Beispiel 3 verfahren, als Farbstoff wird jedoch anstelle von Safranin T der Farbstoff Rhodanilblau (siehe oben) in einer Konzentration von 0,03 % eingesetzt. Bei der Belichtung mit einem Belichter wie in Beispiel 3 erfolgt ein Farbumschlag von Dunkelblau nach Leuchtendrot, der eine sehr gute visuelle Beurteilung der belichteten Druckplatte vor dem Auswaschen erlaubt. Nach dem Auswaschen (vgl. Beispiel 3) resultiert die gewünschte Reliefform. Die Auswertung der hergestellten Reliefstrukturen, die in Tabelle 4 wiedergegeben ist, zeigt die vorteilhafte Ausbildung klebfreier, scharf ausgebildeter Flanken mit vorteilhaften Zwischentiefen eines Rasters mit einem 50%igen Tonwert ($t_z$(50)) und eines negativen Punkts ($t_z$(nP400)).

Vergleichsversuch 4

Es wird wie in Beispiel 4 verfahren, jedoch der Zusatz von Rhodanilblau unterlassen. Stattdessen wird der Triphenylmethanfarbstoff Kristallviolett (C.I. 42 555) in einer Konzentration von 0,01 % eingesetzt. Bei der Belichtung erfolgt praktisch kein Farbumschlag, die Platten können demzufolge vor dem Auswaschen nicht beurteilt werden. Die Auswertung der Reliefstruktur ist in Tabelle 4 wiedergegeben und zeigt eine unbefriedigende Ausbildung der Zwischentiefen $t_z$(50) und $t_z$(nP400) sowie der Flanken

Tabelle 4 Auswertung der Reliefstrukturen, hergestellt gemäß Beispiel 4 und Vergleichsversuch 4

| | Beispiel 4 | Vgl.vers. 4 |
|---|---|---|
| Mindestbelichtungszeit für Raster mit 3%igem Tonwert 60 L/cm | 4,0 Min. | 2,1 Min. |
| Zwischentiefe für Raster (60 L/cm) mit 50%igem Tonwert $t_z(50)$ | 36 µm | 22 µm |
| Zwischentiefe des negativen Punktes 0,4 mm Ø $t_z$ (nP400) | 183 µm | 30 µm |

Beispiel 5

Es wird wie in Beispiel 3 verfahren, als Farbstoff wird jedoch anstelle von Safranin T der Farbstoff Neutralrot (C.I. 50040)in einer Konzentration von 0,02 % eingesetzt. Beim Belichten erfolgt ein Farbumschlag von Rot nach Gelbbraun, der eine gute visuelle Beurteilung der Druckplatte vor dem Entwickeln gestattet. Die Auswertung der durch Auswaschen hergestellten Reliefstrukturen, die in Tabelle 5 wiedergegeben ist, zeigt die vorteilhafte Ausbildung klebfreier, scharf ausgebildete Flanken mit vorteilhaften Zwischentiefen eines Rasters mit einem 50%igen Tonwert ($t_z$(50)) und eines negativen Punktes ($t_z$(nP400)).

Beispiel 6

Es wird wie in Beispiel 5 verfahren. Anstelle des Farbstoffs Neutralrot wird jedoch der Farbstoff Thionin (C.I. 52000) in einer Konzentration von 0,02 % eingesetzt. Bei der Belichtung erfolgt mit einem Farbumschlag von Dunkelblau nach Farblos ein totales Ausbleichen des Farbstoffs. Visuelle Beurteilbarkeit: gut.

Die Auswertung der Reliefstruktur ist in Tabelle 5 wiedergegeben und zeigt gegenüber Vergleichsversuch 3 eine verbesserte Ausbildung der Zwischentiefen $t_z$(50) und $t_z$(nP400) sowie der Flanken.

Tabelle 5

Auswertung der Reliefstrukturen, hergestellt gemäß Beispielen 5 und 6

| | Beispiel 5 | Beispiel 6 |
|---|---|---|
| Mindestbelichtungszeit für Raster mit 3%igem Tonwert 60 L/cm | 2,0 Min. | 10 Min. |
| Zwischentiefe für Raster (60 L/cm) mit 50%igem Tonwert $t_z(50)$ | 42 µm | 30 µm |
| Zwischentiefe des negativen Punktes 0,4 mm Ø $t_z$(nP400) | 250 µm | 140 µm |

Beispiel 7

Auf ein mit einer Polyurethan-Haftschicht versehenes 240 μm starkes Stahlblech wird eine 200 μm dicke Schicht einer photopolymerisierbaren Mischung der folgenden Zusammensetzung aufgebracht:
61 Teile eines alkohollöslichen Copolyamids aus etwa gleichen Teilen Hexamethylendiamin-adipat, 4,4'Diamino-dicyclohexylmethan-adipat und -Caprolactam, 27 Teile des Diethers aus 1 Mol Ethylenglykol und 2 Mol N-Methylolacrylamid, 10 Teile feines Quarzmehl, 2 Teile Benzildimethylketal, 0,3 Teile des Kaliumsalzes des N-Nitrosocyclohexylhydroxylamins, sowie 0,02 Teile des Farbstoffs Safranin T (C.I.50240). Dabei liegen die Mischungsbestandteile in inniger Mischung vor. Die Schicht der photopolymerisierbaren Mischung wird durch eine autotypische Tiefdruckvorlage 2 Min belichtet. Die noch löslichen Schichtanteile der photopolymerisierbaren Mischung werden mit einem Ethanol/Wasser-Gemisch herausgewaschen und die so entwickelte Relieftiefdruckform bei 80°C 30 Min. lang getrocknet. Die Näpfchen der Tiefdruckform sind bis zu 80 μm tief. Dennoch war die Oberfläche der Platte vollkommen eben.

Eine weitere Tiefdruckform wird wie angegeben, jedoch mit einer Belichtungszeit von 10 Min., hergestellt: die Näpfchen sind genauso tief wie bei der 2 Min. lang belichteten und dann entwickelten Relieftiefdruckform.

Vergleichsversuch 5

Wie in Beispiel 7 angegeben, wird eine Tiefdruckform hergestellt, jedoch auf den Zusatz des Farbstoffs Safranin T verzichtet. Nach einer Belichtungszeit von 2 Min. sind die Näpfchen 40 μm tief, wobei die gerasterten Stellen um einige μm tiefer liegen als die nicht-druckenden Stellen. Nach einer Belichtungszeit von 4 Min. sind die Näpfchen nur 25 μm tief und nach 10 Min. Belichtung sind die Näpfchen weniger als 5 μm tief.

Beispiel 8

Es wird wie in Beispiel 3 verfahren, als Farbstoff jedoch anstelle von Safranin T 0,02 % Acridinorange (C.I. 46005) verwendet. Bei der Belichtung erfolgt in den belichteten Schichtanteilen ein Ausbleichen des Farbstoffs. Die Auswertung der hergestellten Reliefstrukturen zeigt Tabelle 6.

Beispiel 9

Es wird wie in Beispiel 8 verfahren, jedoch werden anstelle des Salzes des N-Nitrosocyclohexylamins 0,4 Gew.-% N-Allylthioharnstoff verwendet. Tabelle 6 zeigt die Auswertung der vorteilhaften Reliefstrukturen.

Tabelle 6

Auswertung der Reliefstrukturen, hergestellt gemäß Beispielen 8 und 9

| | Beispiel 8 | Beispiel 9 |
|---|---|---|
| Mindestbelichtungszeit für Raster mit 3%igem Tonwert 60 L/cm | 1,5 Min. | 1,7 Min. |
| Zwischentiefe für Raster (60 L/cm) mit 50%igem Tonwert $t_z(50)$ | 33 μm | 30 μm |
| Zwischentiefe des negativen Punktes 0,4 mm Ø $t_z(nP400)$ | 120 μm | 80 μm |

Beispiel 10

Eine 60%ige wäßrige Lösung eines Gemisches von 60 % eines Polyvinylalkohols eines Verseifungsgrades von 80 Mol% und eines mittleren Molekulargewichtes von etwa 25 000, 20 % des Diethers aus 1 Mol Ethylenglykol und 2 Molen N-Hydroxmethylacrylamid, 18 % 2-Hydroxyethylmethacrylat, 1,5 % Benzoinisopropylether, 0,02 % Safranin T (Color Index Nr. 50240) sowie 0,48 % des Kaliumsalzes des N-Nitrosocyclohexylhydroxylamins wird hergestellt. Die Lösung wird schichtförmig auf ein mit einem Haftlack versehenes Stahlblech (Reflexionsgrad ca. 15 %) so aufgegossen, daß nach dem Trocknen bei etwa 70 °C eine Schicht der photopolymerisierbaren Masse mit einer Schichtstärke von 500 $\mu$m entsteht. Die Photopolymerdruckplatte wird bildmäßig durch eine Vorlage belichtet, mit 40 °C warmem Wasser werden dann die unbelichteten Schichtanteile ausgewaschen.

Farbumschlag bei der Belichtung in einem handelsüblichen Flachbelichter bestückt mit superaktinischen Leuchtstoffröhren ($\lambda_{max.}$~350 bis 400 nm): rot → blaßrot. Visuelle Beurteilung: gut. Die Auswertung der hergestellten Reliefstrukturen, die in Tabelle 7 wiedergegeben ist, zeigt die vorteilhafte Ausbildung klebfreier, scharf ausgebildeter Flanken mit vorteilhaften Zwischentiefen eines Rasters mit einem 50%igen Tonwert ($t_z$(50)) und eines negativen Punkts ($t_z$(nP400)).

Beispiel 11

Es wird genau wie in Beispiel 10 verfahren. Anstelle des Kaliumsalzes des N-Nitrosocyclohexylhydroxylamines wird jedoch ein Gemisch aus 0,3 % Hydrochinonmonomethylether und 0,2 % L(+)-Ascorbinsäure eingesetzt. Die Auswertung der Reliefstruktur ist in Tabelle 7 wiedergegeben.

Vergleichsversuch 6

Es wird genau wie in Beispiel 11 verfahren, jedoch der Zusatz von L(+)-Ascorbinsäure unterlassen. Die Auswertung der Reliefstruktur ist in Tabelle 7 wiedergegeben und zeigt eine unbefriedigende Ausbildung der Zwischentiefen $t_z$(50) und $t_z$(nP400) sowie der Flanken.

Tabelle 7

Auswertung der Reliefstrukturen, hergestellt gemäß Beispielen 10, 11 und Vergleichsversuch 6

| | Beisp.10 | Beisp.11 | Vgl.vers.6 |
|---|---|---|---|
| Mindestbelichtungszeit für Raster mit 3%igem Tonwert 60 L/cm | 3 Min. | 10 Min. | 8 Min. |
| Zwischentiefe für Raster (60 L/cm) mit 50%igem Tonwert $t_z$(50) | 37 $\mu$m | 35 $\mu$m | 28 $\mu$m |
| Zwischentiefe des negativen Punktes 0,4 mm Ø $t_z$(nP400) | 200 $\mu$m | 105 $\mu$m | 32 $\mu$m |

**Patentansprüche**

1. Schicht einer photopolymerisierbaren Mischung für die Herstellung von Relief- und Druckformen, enthaltend
   a) mindestens eine Verbindung mit mindestens einer photopolymerisierbaren olefinisch ungesättigten Doppelbindung,
   b) mindestens einen Photoinitiator, der bei der Belichtung mit UV-Licht eine rasche Photopolymerisation in der Schicht auslöst und der kein Farbstoff ist, sowie
   c) eine bei Belichtung mit aktinischem Licht einer Lichtquelle, die Maxima der Emission im Bereich der Absorption des verwendeten Photoinitiators (b) aufweist und die im Bereich der Absorptionsbande des verwendeten Farbstoffs (c1) eine ausreichende Emission hat, keine merkliche Photopolymerisation in der Schicht auslösende Kombination von

c1) 0,0001 bis 1 Gew.%, bezogen auf die Gesamttrockenmasse der Mischung, eines löslichen Farbstoffs der Formel (I)

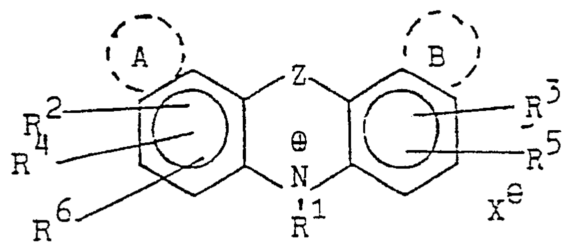

(I),

worin bedeuten
Z = N, 0, S oder $CR^7$
$R^1$ = Wasserstoff, $C_1$-$C_4$-Alkyl, ggf. substituiertes Phenyl oder Naphtyl
$R^2$, $R^3$ = gleich oder verschieden = Wasserstoff, Hydroxy, $C_1$-$C_4$-Alkoxy, Phenoxy, ggf. substituiertes Diarylmethyl, oder $NH_2$, dessen H-Atome ganz oder teilweise durch gleiche oder verschiedene, ggf. substituierte Alkyl, Aryl oder Aralkylreste substituiert sein können,
$R^4$, $R^5$ = gleich oder verschieden = Wasserstoff, $C_1$-C4-Alkyl, Phenyl, Hydroxy, $C_1$-$C_4$-Alkoxy, Sulfo oder $NH_2$, dessen H-Atome ganz oder teilweise durch gleiche oder verschiedene ggf. substituierte Acyl-, Alkyl-, Aryl- oder Aralkylreste substituiert sein können,
$R^6$ = Wasserstoff, Hydroxy, $C_1$-$C_4$-Alkoxy, Carboxyl, Carbalkoxy, N-Acylamino oder Halogen,
$R^7$ = Wasserstoff, $C_1$-$C_4$-Alkyl oder ggf. substituiertes Aryl oder Aralkyl,
$X^-$ = Säureanion,
A,B = gleich oder verschieden, Wasserstoff oder ankondensiertes Benzo-, Naphtho- oder Heterocyclensystem mit Ankondensation in a-, b- oder c-Stellung mit der Maßgabe, daß, wenn A ein ankondensiertes Ringsystem der genannten Art ist, einer der Reste $R^2$ oder $R^4$ entfällt,
mit
c2) einer hinreichenden Menge eines Reduktionsmittels für den Farbstoff (c1), das den Farbstoff (c1) ohne Bestrahlung durch das aktinische Licht nicht reduziert, bei Belichtung mit dem aktinischen Licht den Farbstoff im angeregten Elektronenzustand jedoch reduzieren kann.

2. Schicht einer photopolymerisierbaren Mischung nach Anspruch 1, dadurch gekennzeichnet, daß die Emission im Bereich der Absorption des verwendeten Photoinitiators (b) im Bereich von 300 bis 400 nm liegt.

3. Schicht einer photopolymerisierbaren Mischung nach einem der Ansprüche 1 oder 2, dadurch gekennzeichnet, daß sie als Reduktionsmittel (c2) Ascorbinsäure, Anethol, Thioharnstoff, Diethylallylthioharnstoff, N-Allylthioharnstoff und/oder ein Hydroxylaminderivat enthält.

4. Schicht einer photopolymerisierbaren Mischung nach Anspruch 3, dadurch gekennzeichnet, daß sie als Reduktionsmittel (c2) N-Allylthioharnstoff und/oder ein Salz des N-Nitroso-cyclohexylhydroxylamins enthält.

5. Schicht einer photopolymerisierbaren Mischung nach Anspruch 4, dadurch gekennzeichnet, daß sie als Reduktionsmittel (c2) das Kalium- und/oder das Aluminiumsalz des N-Nitroso-cyclohexylhydroxylamins enthält.

6. Schicht einer photopolymerisierbaren Mischung nach einem der Ansprüche 1 bis 5, dadurch gekennzeichnet, daß sie als Farbstoff (c1) einen löslichen Phenoxaziniumfarbstoff der Formel (I) mit Z = 0 enthält.

7. Schicht einer photopolymerisierbaren Mischung nach einem der Ansprüche 1 bis 5, dadurch gekennzeichnet, daß sie als Farbstoff (c1) einen löslichen Phenaziniumfarbstoff der Formel (I) mit Z = N enthält.

8. Schicht einer photopolymerisierbaren Mischung nach einem der Ansprüche 1 bis 5, dadurch gekennzeichnet, daß sie als Farbstoff (c1) einen löslichen Acridiniumfarbstoff der Formel (I) mit Z = $CR^7$ enthält.

**9.** Schicht einer photopolymerisierbaren Mischung nach einem der Ansprüche 1 bis 5, dadurch gekennzeichnet, daß sie als Farbstoff (c1) einen löslichen Phenothiaziniumfarbstoff der Formel (I) mit Z = S enthält.

**10.** Schicht einer photopolymerisierbaren Mischung nach Anspruch 7, dadurch gekennzeichnet, daß sie als Farbstoff (c1) Neutralrot (C.I. 50040) oder Safranin T (C.I. 50240) enthält.

**11.** Schicht einer photopolymerisierbaren Mischung nach einem der Ansprüche 1 bis 10, dadurch gekennzeichnet, daß sie ein mit der Mischung verträgliches polymeres Bindemittel enthält.

**12.** Verfahren zur Herstellung von Relief- und Druckformen durch bildmäßiges Belichten einer auf einen Träger aufgebrachten Schicht einer photopolymerisierbaren Mischung mit aktinischem Licht und Entwickeln der Relief- und Druckformen durch anschließendes Entfernen, insbesondere Auswaschen der unbelichteten Schichtanteile, dadurch gekennzeichnet, daß man eine Schicht einer photopolymerisierbaren Mischung gemäß einem der Ansprüche 1 bis 11 verwendet.

**13.** Verfahren nach Anspruch 12, dadurch gekennzeichnet, daß man eine Reliefhochdruckform herstellt.

**14.** Verfahren nach Anspruch 12, dadurch gekennzeichnet, daß man eine Relieftiefdruckform herstellt.

## Claims

**1.** A layer of a photopolymerizable mixture for the production of relief plates and printing plates, which contains

(a) one or more compounds having one or more photopolymerizable olefinically unsaturated double bonds,

(b) one or more photoinitiators which, when exposed to UV light, initiates rapid photopolymerization in the layer and is not a dye, and

(c) a combination which, when exposed to actinic light from a light source which has emission maxima in the region of absorption of the photoinitiator (b) used and has adequate emission in the region of the absorption band of the dye (c1) used, does not initiate any perceptible photopolymerization in the layer, and which comprises

(c1) from 0.0001 to 1 % by weight, based on the total dry weight of the mixture, of a soluble dye of the formula (I)

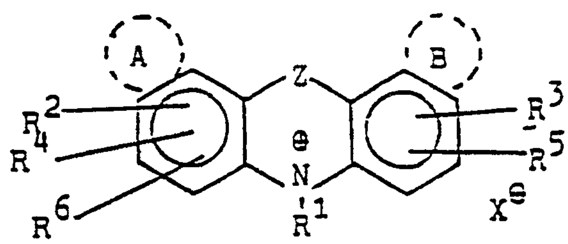

(I)

where Z is N, O, S or $CR^7$, $R^1$ is hydrogen, $C_1$-$C_4$-alkyl or unsubstituted or substituted phenyl or naphthyl, $R^2$ and $R^3$ are identical or different and are each hydrogen, hydroxyl, $C_1$-$C_4$-alkoxy, phenoxy, unsubstituted or substituted diarylmethyl, or $NH_2$ where some or all of the hydrogen atoms can be substituted by identical or different unsubstituted or substituted alkyl, aryl or aralkyl radicals, $R^4$ and $R^5$ are identical or different and are each hydrogen, $C_1$-$C_4$-alkyl, phenyl, hydroxyl, $C_1$-$C_4$-alkoxy, sulfo or $NH_2$ where some or all of the hydrogen atoms can be substituted by identical or different unsubstituted or substituted acyl, alkyl, aryl or aralkyl radicals, $R^6$ is hydrogen, hydroxyl, $C_1$-$C_4$-alkoxy, carboxyl, carbalkoxy, N-acylamino or halogen, $R^7$ is hydrogen, $C_1$-$C_4$-alkyl or unsubstituted or substituted aryl or aralkyl, $X^-$ is an acid anion, and A and B are identical or different and are each hydrogen or a fused benzocyclic, naphthocyclic or heterocyclic

system which is fused on at the a, b or c position, with the proviso that when A is a fused ring system of the stated type, one of the radicals $R^2$ and $R^4$ is absent, with
(c2) an adequate amount of a reducing agent for the dye (c1) which reducing agent does not reduce the dye (c1) without irradiation by actinic light but, on exposure to actinic light, is capable of reducing the dye in the excited electron state.

**2.** A layer of a photopolymerizable mixture as claimed in claim 1, wherein the emission is in the region of the absorption of the photoinitiator (b) used in the range from 300 to 400 nm.

**3.** A layer of a photopolymerizable mixture as claimed in claim 1 or 2, which contains, as reducing agent (c2) ascorbic acid, anethol, thiourea, diethylallylthiourea, N-allylthiourea and/or a hydroxylamine derivative.

**4.** A layer of a photopolymerizable mixture as claimed in claim 3, which contains, as reducing agent (c2), N-allylthiourea and/or a salt of N-nitrosocyclohexylhydroxylamine.

**5.** A layer of a photopolymerizable mixture as claimed in claim 4, which contains, as reducing agent (c2), the potassium and/or aluminum salt of N-nitrosocyclohexylhydroxylamine.

**6.** A layer of a photopolymerizable mixture as claimed in any of claims 1 to 5, which contains, as the dye (c1), a soluble phenoxazinium dye of the formula (I) where Z is O.

**7.** A layer of a photopolymerizable mixture as claimed in any of claims 1 to 5, which contains, as the dye (c1), a soluble phenazinium dye of the formula (I) where Z is N.

**8.** A layer of a photopolymerizable mixture as claimed in any of claims 1 to 5, which contains as the dye (c1), a soluble acridinium dye of the formula (I) where Z is $CR^7$.

**9.** A layer of a photopolymerizable mixture as claimed in any of claims 1 to 5, which contains, as the dye (c1), a soluble phenothiazinium dye of the formula (I) where Z is S.

**10.** A layer of a photopolymerizable mixture as claimed in claim 7, which contains, as the dye (c1), neutral red (C.I. 50040) or safranine T (C.I. 50240).

**11.** A layer of a photopolymerizable mixture as claimed in any of claims 1 to 10, which contains a polymeric binder which is compatible with the mixture.

**12.** A process for the production of relief plates and printing plates by exposing a layer of a photopolymerizable mixture applied on a base imagewise to actinic light and developing the relief or printing plate by subsequently removing the unexposed areas of the layer, in particular by washing them out, wherein a layer of a photopolymerizable mixture as claimed in any of claims 1 to 11 is used.

**13.** A process as claimed in claim 12, wherein a relief plate for letterpress printing is produced.

**14.** A process as claimed in claim 12, wherein a relief plate for gravure printing is produced.

**Revendications**

**1.** Couche d'un mélange photopolymérisable pour la fabrication de formes d'impression et de clichés en relief, qui contient
a) au moins un composé qui comporte au moins une double liaison à insaturation oléfinique photopoly
mérisable, b) au moins un photoamorceur, qui provoque une photopolymérisation rapide dans la couche par exposition à de la lumière ultraviolette et qui n'est pas un colorant, comme aussi
c) une combinaison qui ne provoque pas de photopolymérisation notable dans la couche lors de l'exposition à de la lumière actinique provenant d'une source de lumière qui présente des maxima de l' émission dans la plage de l'absorption du photoamorceur (b) utilisé et qui possède une émission suffisante dans la plage de la bande d'absorption du colorant (c1) utilisé, constituée de

c1) 0,0001 à 1% en poids, par rapport à la masse sèche globale du mélange, d'un colorant soluble de la formule (I)

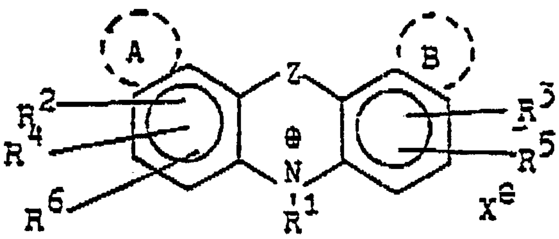

(I),

dans laquelle

Z représente un atome d'azote, d'oxygène de soufre ou le radical $CR^7$,

$R^1$ représente un atome d'hydrogène, un radical alkyle en $C_1$-$C_4$, un radical naphtyle, ou phényle, éventuellement substitué,

$R^2$ et $R^3$ qui peuvent être identiques ou différents, représentent chacun un atome d'hydrogène, un radical hydroxyle, alcoxy en $C_1$-$C_4$, phénoxy, diarylméthyle éventuellement substituè, ou $NH_2$ dont les atomes d'hydrogène peuvent être totalement ou partiellement substitués par des radicaux aralkyle, aryle, ou aryle, éventuellement substitués, identiques ou différents,

$R^4$ et $R^5$ qui peuvent être identiques ou différents, représentent chacun un atome d'hydrogène, un radical alkyle en $C_1$-$C_4$, phényle, hydroxyle, alcoxy en $C_1$-$C_4$, sulfo, ou $NH_2$ dont les atomes d'hydrogène peuvent être totalement ou partiellement substitués par des radicaux aralkyle, aryle, alkyle ou acyle, éventuellement substitués, identiques ou différents,

$R^6$ représente un atome d'hydrogène, un radical hydroxyle. alcoxy en $C_1$-$C_4$. carboxyle, carbalcoxy, N-acylamino ou un atome d'halogène,

$R^7$ représente un atome d'hydrogène, un radical alkyle en $C_1$-$C_4$ ou un radical aralkyle, ou aryle, éventuellement substitué,

$X^-$ représente un anion d'acide,

A,B qui peuvent être identiques ou diffférents, représentent chacun un atome d'hydrogène ou un système benzénique, naphténique ou hétérocyclique condensé avec condensation en position a, b ou c et avec la condition que lorsque A représente un système cyclique condensé de la nature précitée, l'un des substituants $R^2$ et $R^4$ n'est pas présent,

et de

c2) une proportion d'un agent réducteur pour le colorant (c1), qui suffit à ne pas réduire le colorant (c1) sans exposition à de la lumière actinique mais, cependant, à réduire le colorant à l'état électronique excité par une exposition à de la lumière actinique.

**2.** Couche d'un mélange photopolymérisable selon la revendication 1, caractérisée en ce que l'émission dans la plage de l'absorption du photoamorceur (b) utilisé se situe dans la plage de 300 à 400 nm.

**3.** Couche d'un mélange photopolymérisable selon l'une des revendications 1 et 2, caractérisée en ce qu'elle contient, à titre d'agent réducteur (c2), de l'acide ascorbique, de l'anéthol, de la thiourée, de la diéthylallylthiourée, de la N-allylthiourée et/ou un dérivé d'hydroxylamine.

**4.** Couche d'un mélange photopolymérisable selon la revendication 2, caractérisée en ce qu'elle contient, à titre d'agent réducteur (c2), de la N-allylthiourée et/ou un sel de la N-nitroso-cyclohexylhydroxylamine.

**5.** Couche d'un mélange photopolymérisable suivant la revendication 4, caractérisée en ce qu'elle contient, à titre d'agent réducteur (c2), le sel de potassium et/ou le sel d'aluminium de la N-nitroso-cyclohexylhydroxylamine.

**6.** Couche d'un mélange photopolymérisable suivant l'une des revendications 1 à 5, caractérisée en ce qu'elle contient, à titre de colorant (c1), un colorant du type phénoxazinium, soluble, de la formule (I) dans laquelle Z est égal à 0.

**7.** Couche d'un mélange photopolymérisable suivant l'une des revendications 1 à 5, caractérisée en ce

qu'elle contient, à titre de colorant (c1), un colorant du type phénazinium, soluble, de la formule (I) dans laquelle Z représente un atome d'azote.

8. Couche d'un mélange photopolymérisable selon l'une des revendications 1 à 5, caractérisée en ce qu'elle contient, à titre de colorant (c1), un colorant du type acrylinium, soluble, de la formule (I) dans laquelle Z représente un radical $CR^7$.

9. Couche d'un mélange photopolymérisable suivant l'une des revendications 1 à 5, caractérisée en ce qu'elle contient, à titre de colorant (c1), un colorant du type phénoxthiazinium, soluble, de la formule (I) dans laquelle Z représente un atome de soufre.

10. Couche d'un mélange photopolymérisable suivant la revendication 7, caractérisée en ce qu'elle contient, à titre de colorant (c1), le rouge neutre (C.I. 50040) ou la safranine T (C.I. 50240).

11. Couche d'un mélange photopolymérisable suivant l'une des revendications 1 à 10, caractérisée en ce qu'elle contient un liant polymérique, compatible avec le mélange.

12. Procédé de fabrication de formes d'impression et de clichés en relief par l'exposition à de la lumière actinique, en conformité d'image, d'une couche d'un mélange photopolymérisable, déposée sur un support et le développement des formes d'impression et de clichés en relief par dépouillement subséquent, plus particulièrement lixiviation des parties de la couche non exposées, caractérisé en ce que l'on utilise une couche d'un mélange photopolymérisable selon l'une quelconque des revendications 1 à 11.

13. Procédé suivant la revendication 12, caractérisé en ce que l'on fabrique un cliché en relief pour l'impression typographique.

14. Procédé suivant la revendication 12, caractérisé en ce que l'on fabrique un cliché en relief pour l'impression en héliogravure ou rotogravure.

FIG. 1

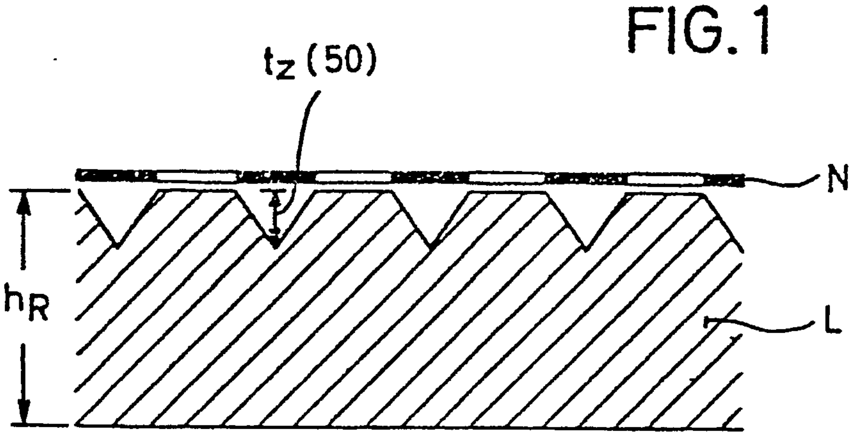


FIG. 2